# EUROPEAN PATENT APPLICATION

(11) **EP 0 769 725 A2**
(43) Date of publication of application: **23.04.1997**
(21) Application number: 96116782.2
(22) Date of filing: 18.10.1996
(51) Int. Cl.: G03F 7/30

(54) **Photoresist development method and apparatus**

(30) Priority: 20.10.1995 US 576295
(71) Applicant: TEXAS INSTRUMENTS INCORPORATED, Dallas Texas 75265 (US)
(72) Inventor: Palmer, Shane R., Dallas TX 75243 (US)
(74) Representative: Schwepfinger, Karl-Heinz, Dipl.-Ing.

(57) **Abstract**

Photoresist development is provided by the placement of a photoresist layer (12) and a wafer (14) beneath a source of liquid developer. After the liquid developer is applied to the top surface (13) of the photoresist layer (12), an ultrasonic signal is applied to the photoresist layer (12) by an ultrasonic coupling device (18). An upper rotor (16) rotates the photoresist layer (12) and wafer (14) for the removal of liquid developer from photoresist layer (12).

## Description

### TECHNICAL FIELD OF THE INVENTION

This invention relates in general to the field of semiconductors and more particularly to an improved system and method for photoresist processing and development.

### BACKGROUND OF THE INVENTION

The uniform development of very fine and detailed photoresist features during semiconductor fabrication is hindered by the increasing size of semiconductor wafers and the decreasing geometry of the photoresist features. Despite the increase in the surface area of semiconductor wafers and the decrease in the geometry of photoresist features, the thickness of the photoresist layer has not changed considerably. As a result, photoresist features are becoming increasingly narrow with larger and larger aspect ratios. The aspect ratio of a photoresist feature is the ratio of the height of the feature to the width of the interior of the feature. The height of a photoresist feature is equal to the thickness of the photoresist layer. Thus, a photoresist feature with a high aspect ratio has a narrow interior compared to its height, while a photoresist feature with a low aspect ratio has a wide interior compared to its height.

During the development, or removal, of the exposed photoresist features, the exposed photoresist features with low aspect ratios are more easily removed by the developer than are the exposed photoresist features with high aspect ratios. The refresh rate of the developer is a measure of the rate at which spent developer is replaced. The refresh rate is diminished in those exposed photoresist features with high aspect ratios. Because of the diminished refresh rate of the developer in exposed photoresist features with high aspect ratios, these features are more slowly removed than are exposed photoresist features with low aspect ratios.

Several techniques have been employed in an attempt to uniformly develop exposed photoresist features. One such technique involves spraying developer on the photoresist layer and rapidly rotating the wafer. This technique, however, sometimes results in uneven development of the exposed photoresist features. The centrifugal force experienced by the photoresist features, especially at the edges of the wafer, can become quite severe and can cause photoresist features to fall over. In addition, the rotational action of the wafer in combination with the frictional and chemical force between the developer and the photoresist layer causes an extreme outward flow of the developer away from the center of the wafer, which in turn may lead to uneven development of the exposed photoresist features.

Puddle development is a second technique that has been used to develop exposed photoresist features. Puddle development involves the dispensing of an even puddle of developer across the wafer. Often, however, uneven development will result because the wafer will not have a uniform number of photoresist features per local area across the wafer. Additionally, the developer will often stagnate and the development, or removal, of the photoresist layer will cease due to the dilution of the developer in narrow photoresist features. In narrow photoresist features, diffusion cannot adequately refresh the developer, and the developer becomes increasingly less concentrated and therefore less effective within narrow photoresist features. As a result, narrow photoresist features are removed more slowly than are wider photoresist features.

Still another technique used to develop photoresist features is the dunk, or immersion development technique. Dunk development techniques, however, are expensive and the developer liquid is susceptible to contamination. Also, the full immersion "dunk process" does not fully resolve the refresh (spent development removal) problem with high aspect ratio features.

### SUMMARY OF THE INVENTION

Therefore, a need has arisen for a system and method for photoresist development able to uniformly develop photoresist features without damaging the photoresist features. In accordance with the present invention, a photoresist development system and method is provided that substantially eliminates or reduces the disadvantages and problems associated with previously established photoresist development techniques.

According to one embodiment of the present invention, a layer of photoresist having a number of undeveloped features is placed on a semiconductor wafer. A rotor rotates the wafer and photoresist layer as one or more spray nozzles sprays developer on the surface of the photoresist layer. While the developer is being sprayed on the surface of the photoresist layer, an ultrasonic coupling device coupled to the rotor provides an ultrasonic agitation signal to the wafer and the photoresist layer. The ultrasonic signal applied to the photoresist layer provides agitation and promotes the uniform development of the exposed photoresist features by aiding the diffusion of developer and increasing the refresh rate of the developer in narrow photoresist features.

According to another embodiment of the invention, a puddle of developer is deposited on the surface of the photoresist layer. The puddle of developer remains on the photoresist layer for a period of time while an ultrasonic agitation signal is applied to the photoresist layer.

An important technical advantage of the disclosed photoresist development system and method is the uniform development of exposed photoresist features. A second technical advantage of the disclosed photoresist development system is a reduction in photoresist development costs. Another technical advantage of the disclosed photoresist development system is a reduction in photoresist development time. Still another technical advantage of the disclosed photoresist development system is an improved capacity to develop photoresist layers having large surface areas.

### BRIEF DESCRIPTION OF THE DRAWINGS

A more complete understanding of the present invention and the advantages associated therewith may be acquired by referring to the accompanying drawings in which like reference numbers indicate like features and wherein:
FIGURE 1 is a graphical representation of one embodiment of an ultrasonically coupled photoresist development system constructed according to the teachings of the present invention; and
FIGURE 2 is a graphical representation of another embodiment of an ultrasonically coupled photoresist development system constructed according to the teachings of the present invention.

### DETAILED DESCRIPTION OF THE INVENTION

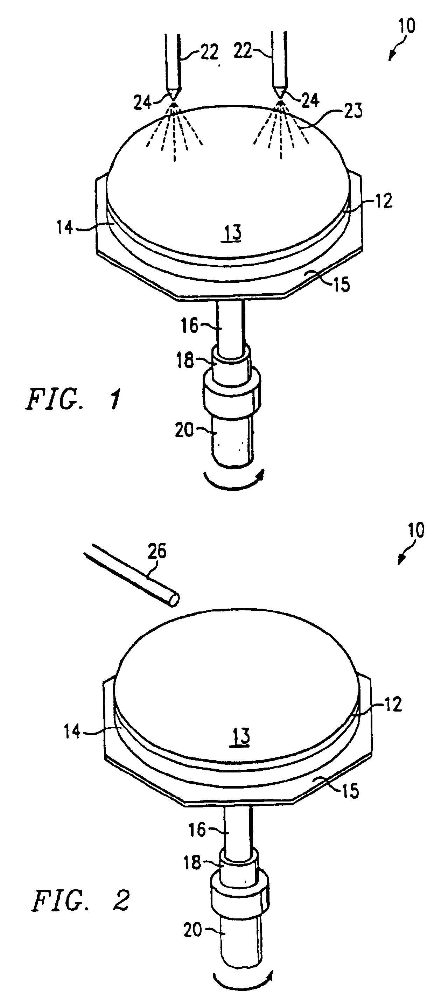

FIGURE 1 is a graphical representation of the ultrasonically coupled photoresist development system indicated generally at 10. A layer of photoresist 12 is coated onto a semiconductor wafer 14 according to standard photolithographic techniques. Semiconductor wafer 14 may comprise, for example, silicon. After photoresist layer 12 is placed on wafer 14, exposed patterns of photoresist layer 12 are created by exposing photoresist layer 12 to light according to standard photolithographic techniques. Photoresist layer 12 has a top surface 13.

A developer is applied to the surface 13 of photoresist layer 12. The developer is a liquid that is placed on and chemically removes the exposed photoresist features. In a positive photoresist environment, the developer removes the exposed photoresist features. In a negative photoresist environment, the developer removes the unexposed photoresist features. Although the present invention will be described in the positive photoresist environment, the described invention is not limited to application in a positive photoresist environment, but can likewise be applied in a negative photoresist environment.

A chuck 15 supports photoresist layer 12 and wafer 14. Chuck 15 stabilizes photoresist layer 12 and wafer 14 during the development, or removal, of the exposed photoresist features by the developer. An upper rotor 16 is coupled to the bottom surface of chuck 15. An ultrasonic coupling device 18 connects upper rotor 16 to lower rotor 20.

In the embodiment of the present invention shown in FIGURE 1, a liquid developer source comprising one or more spray nozzles 22 is positioned above photoresist layer 12 and wafer 14. Each of spray nozzles 22 has a fine tip 24 and delivers a gentle developer spray 23 across the top surface 13 of photoresist layer 12. Spray nozzles 22 deliver a volume of developer spray 23 across the surface 13 of photoresist layer 12 so that each portion of the surface 13 of photoresist layer 12, whether in the center or perimeter of surface 13, receives roughly the same amount of developer spray 23 from spray nozzle 22.

According to one embodiment of the present invention, upper rotor 16 rotates photoresist layer 12 and wafer 14 slowly under the developer spray from spray nozzles 22. Photoresist layer 12 and wafer 14 may rotate at about 50 to 300 rpm. Developer spray 23 from spray nozzles 22 accumulates on top surface 13 of photoresist layer 12. As photoresist layer 12 slowly rotates, the developer forming on surface 13 of photoresist layer 12 is spun off the sides of photoresist layer 12. The slow rotation of photoresist layer 12 limits the size of the puddle forming on top surface 13 of photoresist layer 12. In the absence of rotation, the size of an accumulated puddle of developer on surface 13 of photoresist layer 12 would be larger and would be limited only by the viscous forces holding the liquid on surface 13. The slow rotation of photoresist layer 12 aids the roughly uniform dispersement of developer spray 23 across top surface 13 of photoresist layer 12.

During the spraying of the developer on top surface 13 of photoresist layer 12, ultrasonic coupling device 18 agitates the developer on surface 13 of photoresist layer 12. Ultrasonic coupling device 18 provides an ultrasonic agitation signal to the developer accumulated on top surface 13 of photoresist layer 12. The ultrasonic agitation signal is directed along the circumferential axis of upper rotor 16. The ultrasonic coupling signal provided by ultrasonic coupling device 18 may be in the form of mechanical agitation at an ultrasonic frequency. The ultrasonic coupling signal could also be in the form of an ultrasonic waveform, i.e., sound directed at the top section of the wafer. The agitation provided to the developer accumulated on photoresist layer 12 is an aid to the normal diffusion of the developer in the features of photoresist layer 12. Thus, for the case of narrow photoresist features, the ultrasonic agitation from ultrasonic coupling device 18 increases the refresh rate of the developer within those features so that the exposed photoresist features of photoresist layer 12 are developed uniformly without regard to the aspect ratio of the features.

Thus, while spray nozzles 22 continuously supply developer to surface 13 of photoresist layer 12, the ultrasonic agitation provided by ultrasonic coupling device 18 delivers sufficient agitation to photoresist layer 12 to refresh or diffusively replace the spent or diluted developer in the features of photoresist layer 12. Diluted developer is replaced by fresh developer from spray nozzles 22. Meanwhile, excess developer is spun off top surface 13 of photoresist layer 12 by the slow rotation of photoresist layer 12.

For the case of mechanical agitation, ultrasonic coupling device 18 may be any sort of mechanical device able to provide an ultrasonic vibration in the direction of the circumferential axis of upper rotor 16. One such device could include a pair of magnets separated by a spring and polarized such that they tend to alternately repel and attract at an ultrasonic frequency. As an alternative to mechanical agitation, ultrasonic coupling device may provide an ultrasonic waveform propagating in the direction of the circumferential axis of upper rotor 16.

A second embodiment of the present invention is shown in FIGURE 2. As shown in FIGURE 2, a liquid developer source comprising a hose 26 places a volume of developer in the form of a puddle on surface 13 of photoresist layer 12. The volume of the developer placed on surface 13 of photoresist layer 12 is premeasured so that viscous forces hold the developer into a dome of liquid on surface 13 of photoresist layer 12. As in the case of the spray technique discussed previously, ultrasonic coupling device 18 delivers an ultrasonic agitation signal to the developer puddle 28 on the surface 13 of photoresist layer 12. The agitation signal aids the diffusion of the developer within narrow photoresist features on photoresist layer 12. As a result of the agitation of the developer within the narrow photoresist features of photoresist layer 12, the refresh rate of the developer is increased and the features of photoresist layer 12 develop uniformly.

Ultrasonic frequencies are generally regarded as those frequencies above the human ear's audibility limit of 20 kHz. The magnitude and frequency of the ultrasonic agitation signal must be adjusted so that photoresist layer 12 is not separated from wafer 14 and wafer 14 is not separated from chuck 15. Similarly, frequency and amplitude must be monitored so that resonance effects are avoided. The frequency of the amplitude of the ultrasonic agitation signal may be either constant or varying.

Aside from improving the uniform development of exposed photoresist features, the application of the photoresist development system of the present invention decreases the time and the amount of developer needed to remove exposed photoresist features. The photoresist development system of the present invention also provides a system for developing photoresist layers having increasingly larger surface areas. As increasingly larger wafers are implemented, the photoresist development system of the present invention provides a system and method by which a large photoresist layer can rotate at low angular velocities under a developer spray and an ultrasonic agitation signal applied to the photoresist layer can increase the refresh rate of developer within the photoresist features.

Although the present invention has been described in detail, it should be understood that various changes, alterations, and substitutions may be made to the teachings herein without departing from the spirit and scope of the present invention.

## Claims

1. A method for developing features in a photoresist layer on a surface of a substrate, which method comprising;
depositing developer on the surface of the photoresist layer;
applying an agitation signal to the substrate, thereby causing agitation of said developer; and
removing the developer from the surface of the photoresist layer.

2. The method of Claim 1, wherein the step of applying the agitation signal comprises applying an ultrasonic agitation signal to the substrate such that developer on the surface of the substrate is ultrasonically excited.

3. The method of Claim 1 or Claim 2, wherein the step of applying the agitation signal comprises applying an ultrasonic agitation signal in the form of a mechanical vibration to the substrate.

4. The method of any preceding claim, wherein the step of removing the developer comprises spinning the developer from the surface of the photoresist layer.

5. The method of any preceding claim further comprising;
rotating the substrate.

6. The method of Claim 5, wherein the step of depositing the developer comprises spraying the photoresist layer with a volume of developer.

7. A photoresist developments system for developing a photoresist layer on a substrate, which system comprising;
a liquid developer source arranged to deposit developer on a surface of the photoresist layer;
a chuck for receiving the substrate;
an agitation device coupled to the chuck for providing an agitation signal to the substrate, to thereby cause agitation of said developer.

8. The system as claimed in Claim 7, wherein the liquid developer source comprises at least one spray nozzle.

9. The system as claimed in Claim 7 or Claim 8, wherein the agitation device is capable of providing an ultrasonic signal.

10. The system as claimed in any of Claims 7 to 9, wherein the agitation device is capable of providing an ultrasonic signal in the form of a mechanical vibration.

11. The system as claimed in Claim 10, wherein the agitation device comprises a pair of magnets separated by a spring, the magnets being polarised to provide an agitation signal in the form of mechanical vibrations.

12. The system as claimed in any of Claims 7 to 11 further comprising;
a rotor coupled to the chuck, and capable of providing rotation thereof.
